# EUROPEAN PATENT APPLICATION

(11) **EP 1 365 415 A1**
(43) Date of publication of application: **26.11.2003**
(21) Application number: 03253111.3
(22) Date of filing: 19.05.2003
(51) Int. Cl.: G11C 11/15, G11C 11/16

(54) **MRAM with voltage sources for selected and non-selected word lines and selected and non-selected bit lines**

(30) Priority: 22.05.2002 US 151913
(71) Applicant: Hewlett-Packard Company, Palo Alto, CA 94304 (US)
(72) Inventor: Perner, Frederick A., Palo Alto, CA 94306 (US); Tran, Lung T., Saratoga, CA 95070 (US); Eaton, James R., Palo Alto, California 94306 (US)
(74) Representative: Powell, Stephen David

(57) **Abstract**

In a data storage device that includes an array (165) of resistive memory cells (170,173,175,177) and a circuit that is electrically connected to the array (165), the resistive memory cells (170,173,175,177) include magnetic random access memory cells (265) that are electrically connected to diodes (260). The circuit is capable of applying a first voltage to some of the resistive memory cells (170,173,175,177) in the array (165), a second voltage to other cells (170,173,175,177) in the array (165), and a third voltage to yet other cells (170,173,175,177) in the array (165). The circuit is used in a method of sensing the resistance state of a selected resistive memory cell (175).

## Description

The present application concerns data storage devices and a method of sensing resistance states therein, especially equi-potential sensing magnetic random access memory (MRAM) with series diodes.

The application is related to European patent application.....................filed on even date and entitled Sensing Data Storage Devices, claiming priority from US Application 10/151,915 (Attorney Docket No. HP 100111472/N13387), and to European patent application............................filed on even date and entitled Memory Cell Isolation, claiming priority from US Application 10/151,914 (Attorney Docket No. HP 100111473/N13386). These applications are incorporated herein in their entirety by reference.

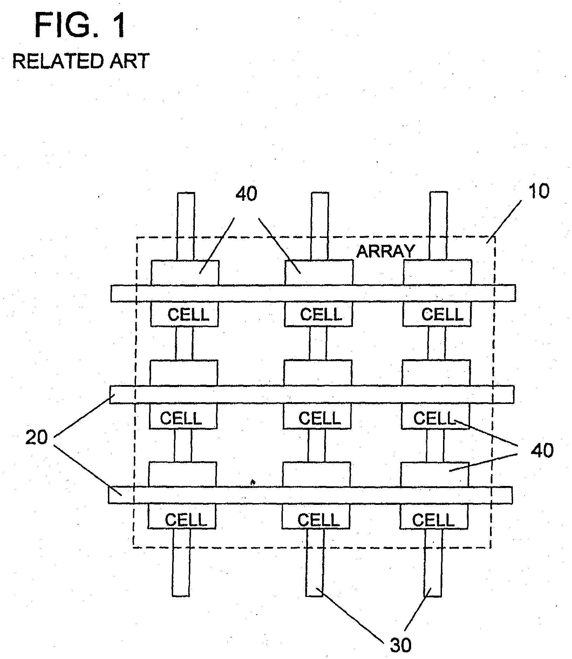

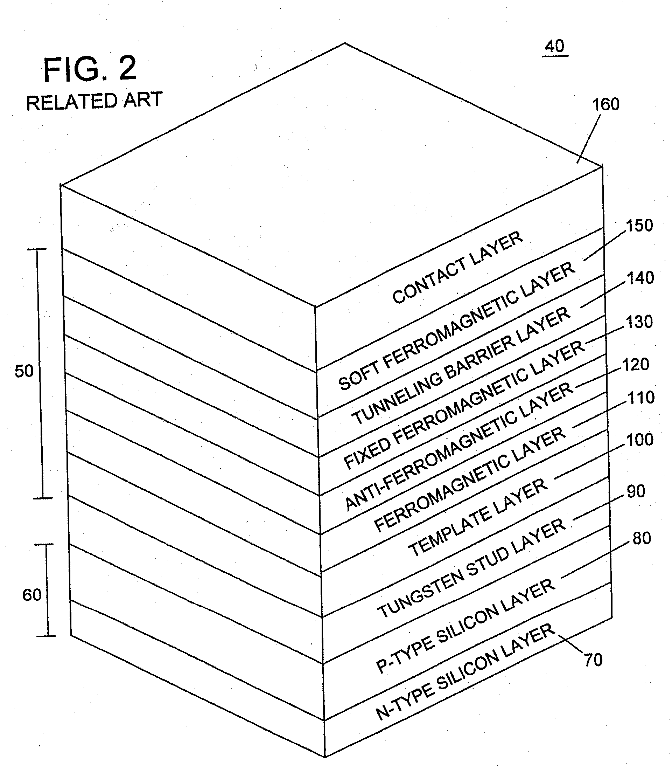

The related art discloses non-volatile magnetic random access memory (MRAM) cells that are positioned in an array 10, as illustrated in FIG. 1. The array 10 includes a plurality of word lines 20 that extend along rows of the array 10 and a plurality of bit lines 30 that extend along columns of the array 10. The word lines 20 and bit lines 30 criss-cross each other and intersect. Between the word lines 20 and bit lines 30, at locations where they intersect, are included MRAM memory cells 40 that, as illustrated in FIG. 2, each include a magnetic tunnel junction (MTJ) 50 and a silicon junction diode 60.

FIG. 2 illustrates a side perspective view of an MRAM memory cell 40 as disclosed in the related art. FIG. 2 shows an n-type silicon layer 70 in contact with a word line 20 (not shown in FIG. 2). On top of the n-type silicon layer 70 is a p-type silicon layer 80 that, together with the n-type silicon layer 70, make up the silicon junction diode 60. Adjacent to this silicon junction diode 60 is formed a tungsten stud layer 90 and a template layer 100. Above the template layer 100 are a ferromagnetic layer 110, an anti-ferromagnetic layer 120, a fixed ferromagnetic layer 130, a tunneling barrier layer 140, a soft ferromagnetic layer 150, and a contact layer 160 that provides an electrical contact to a bit line 30 (not shown in FIG. 2),

Initially, the MRAM memory cell 40 may be in a first resistance state, also known as a parallel state, where the soft ferromagnetic layer 150 is in a first direction of magnetization that is the same direction of magnetization as that of the fixed ferromagnetic layer 130. Alternately, the MRAM memory cell 40 may be in a second resistance state, also known as an anti-parallel state, where the soft ferromagnetic layer 150 is in a second direction of magnetization that is different from the direction of magnetization of the fixed ferromagnetic layer 130.

When writing to an MRAM memory cell 40 in the array 10, potentials are applied to both the word line 20 and bit line 30 that are adjacent to the MRAM memory cell 40. These potentials generate currents that travel through the selected word line 20 and the selected bit line 30. The currents, in turn, generate magnetic fields that are coupled to the selected MRAM memory cell 40 with a sufficient combined intensity to alter the direction of magnetization of the soft ferromagnetic layer 150.

Hence, when being written to, the MRAM memory cell 40 may experience a measurable increase in resistance if the coupled magnetic fields change the MRAM memory cell 40 from the first resistance state to the second resistance state. On the other hand, if the MRAM memory cell 40 is changed, by the coupled magnetic fields, from the second resistance state to the first resistance state, the MRAM memory cell 40 will experience a measurable decrease in resistance.

In other words, the resistance of an MRAM memory cell 40 is a function of the relative directions of magnetization of the fixed ferromagnetic layer 130 and of the soft ferromagnetic layer 150. When the directions of magnetization are parallel, more current can flow through the tunneling barrier layer 140 and the resistance is measurably lower than the when the directions of magnetization are anti-parallel.

During a reading step, the resistance of the MRAM memory cell 40 is detected by passing an amount of current through the MRAM memory cell 40. Then, the resistance of the MRAM memory cell 40 is monitored and, by sensing whether the MRAM memory cell 40 is in a high resistance state or a low resistance state, it is possible to determine whether the MRAM memory cell 40 is in the parallel or anti-parallel state. In other words, it is possible to determine whether the MRAM memory cell 40 contains a"0" data bit or a "1" data bit.

During the reading step, in order to electrically isolate the MRAM memory cell 40 being read, the array 10 discussed above relies on the silicon junction diode 60 having low leakage properties. However, small, thin-film diodes 60 have a tendency to leak current. Further, as more small, thin-film diodes 60 are included in larger arrays 10, the aggregate amount of leakage current in the array 10 increases. Hence, especially in larger arrays 10, the amount of leakage current in the array 10 can interfere with the accurate measurement of the resistance state of the MRAM memory cell 40 being monitored, thereby rendering the data storage device that includes the array 10 ineffective.

A data storage device consistent with the present invention includes an array of resistive memory cells and a set of diodes electrically connected in series to a plurality of resistive memory cells in the array. A plurality of word lines extend along rows of the array and a plurality of bit lines extend along columns of the array. A first selected resistive memory cell in the array is positioned between a first word line in the plurality of word lines and a first bit line in the plurality of bit lines. A circuit is electrically connected to the array and capable of applying a first voltage to the first word line, a second voltage to the first bit line, and a third voltage to at least one of a second word line in the plurality of word lines and a second bit line in the plurality of bit lines.

A method consistent with the present invention senses a resistance state of a first selected resistive memory cell in a data storage device that includes an array of resistive memory cells. The method includes providing a set of diodes electrically connected in series to a plurality of resistive memory cells in the array, applying a first voltage to the first word line, a second voltage to the first bit line, and a third voltage to at least one of a second word line in the plurality of word lines and a second bit line in the plurality of bit lines, and sensing a signal current flowing through the first selected resistive memory cell.

Data storage devices and methods will be described, by way of example, in the description of exemplary embodiments, with particular reference to the accompanying drawings in which like numbers refer to like elements and:
FIG. 1 illustrates a plan view of an array of MRAM memory cells according the related art;
FIG. 2 illustrates a side perspective view of an MRAM memory cell according to the related art;
FIG. 3A illustrates a plan view of a resistive memory cell array, a voltage and ground electrically connected to the array, equivalent circuits representing components in the array, and paths of currents that may flow through the array;
FIG. 3B illustrates a plan view of a resistive memory cell array, two voltages applied to bit lines of the array, equivalent circuits representing components in the array, and paths of currents that may flow through the array;
FIG. 3C illustrates a plan view of a resistive memory cell array, a voltage applied to a bit line of the array, a voltage applied to a word line of the array, equivalent circuits representing components in the array, and paths of currents that may flow through the array;
FIG. 4 illustrates a side perspective view of one embodiment of a resistive memory cell that may be included in the arrays illustrated in FIGS. 3A-C;
FIG. 5 illustrates a side perspective view of two resistive memory cells in a stacked configuration; and
FIG. 6 is a flowchart of methods that may be used to read data from a data storage device that includes arrays such as those illustrated in FIGS. 3A-C.

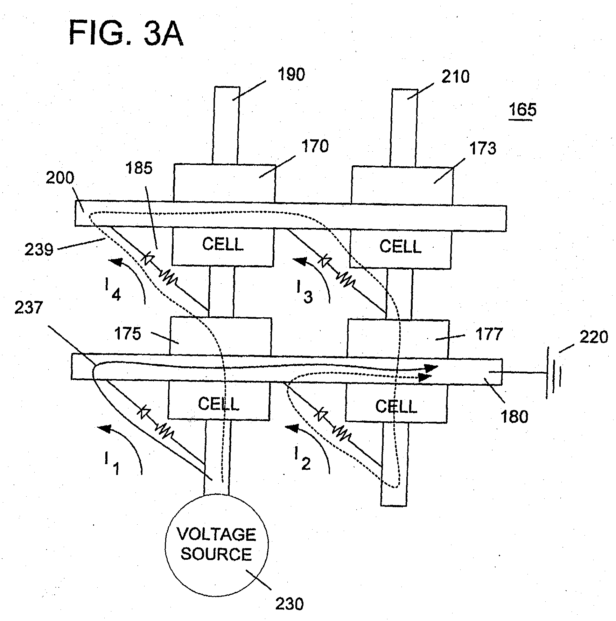

FIGS. 3A-C each illustrate an array 165 of resistive memory cells 170, 173, 175, 177. Each array 165 includes one selected word line 180, one selected bit line 190, and one selected resistive memory cell 175, located at the intersection of the selected word line 180 and the selected bit line 190. Each array 165 also includes an unselected word line 200 and an unselected bit line 210.

Further, each array 165 includes a first unselected resistive memory cell 170, which represents unselected resistive memory cells located on the selected bit line 190, a second unselected resistive memory cell 177, which represents unselected resistive memory cells located on the selected word line 180, and a third unselected resistive memory cell 173, which represents unselected resistive memory cells that are neither on the selected word line 180 nor on the selected bit line 190. Although only four resistive memory cells 170, 173, 175 177, two bit lines 190, 210, and two word lines 180, 200 are illustrated, additional resistive memory cells, bit lines, and word lines may be included in the array 165.

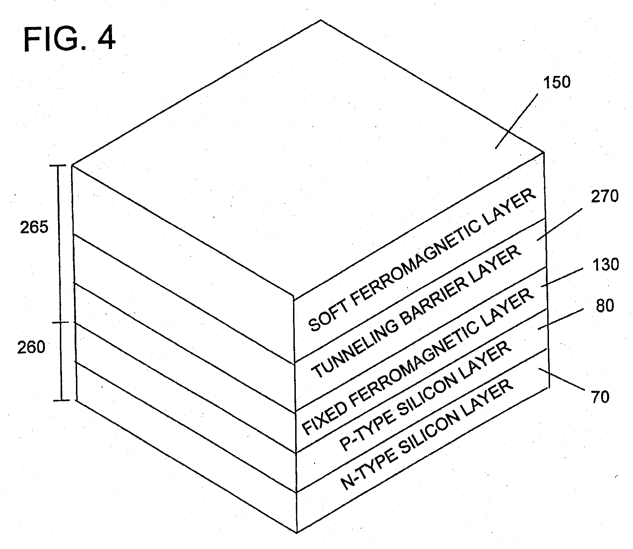

FIG. 4 illustrates one possible resistive memory cell configuration that may be used in any of the arrays 165 illustrated in FIGS. 3A-C. A diode 260 is illustrated at the bottom of FIG. 4, and an MRAM memory cell 265 is illustrated adjacent to the diode 260. Both the MRAM memory cell 265 and the diode 260 may be positioned between a word line 180, 200 and a bit line 190, 210 in an array 165. Further, the diode 260 and the MRAM memory cell 265 may be electronically connected in series with each other. Also, although the diode 260 illustrated includes a p-type silicon layer 80 on top of an n-type silicon layer 90, the configuration of the diode 260 layers 80, 90 may be reversed and other know diode 260 configurations may be used.

The diode 260 may be a thin-film diode made from any material known in the art and may take any geometry known in the art. The MRAM memory cell 265 may include the fixed ferromagnetic layer 130, tunnel barrier layer 140, and soft ferromagnetic layer 150 illustrated in FIG. 4. In addition, the MRAM memory cell 265 may include any of the layers illustrated in FIG. 2 and any additional layers that one skilled in the art would know to use in conjunction with, or as a part of, an MRAM memory cell 265.

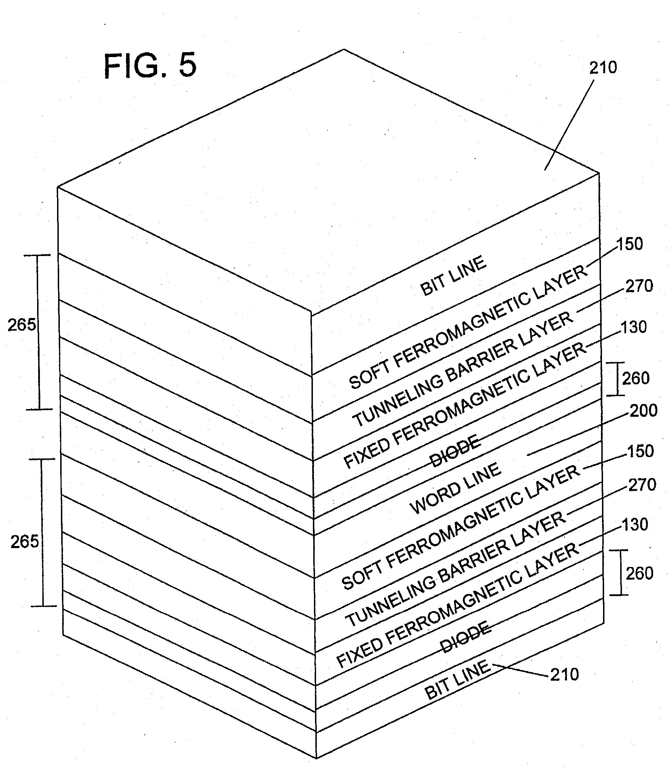

FIG. 5 illustrates a resistive memory cell configuration wherein two resistive memory cells are stacked upon each other and wherein both resistive memory cells are MRAM memory cells 265 with adjacent diodes 260. The MRAM memory cell 265 illustrated in the lower portion of FIG. 5 is surrounded by a lower bit line 210 and a word line 200. Above the word line 200 is positioned the second MRAM memory cell 265, capped by an upper bit line 210.

The lower MRAM memory cell 265 in FIG. 5 may be positioned in a first layer of any of the arrays 165 shown in FIGS. 3A-C and the second MRAM memory cell 265 may be positioned in a second layer that is stacked upon the first layer. Stacking resistive memory cells, as shown in FIG. 5, can increase the data storage density of a data storage device.

Although MRAM memory cells 265 are illustrated in FIG. 5, other types of resistive memory cells 170 may be used in the data storage devices discussed herein. Also, more than two resistive memory cells 170 may be stacked on top of each other. Further, although the bottom-most word line 180 and left-most bit line 190 are selected in FIGS. 3A-C, any bit line and word line in the array 165 may be chosen as a selected line. Hence, any of the resistive memory cells 170, 173, 175, 177 may become the selected resistive memory cell 175.

The circuits illustrated in FIGS. 3A-C have previously been described, along with additional components, in U.S. Patent No. 6,259,644 B1 to Tran et al. (the '644 patent). The entire contents of the '644 patent are incorporated herein by reference. Circuit components particularly relevant to the data storage devices illustrated in FIGS. 3A-C will be discussed herein, with the understanding that any or all circuit components disclosed in the '644 patent may be used in conjunction with the arrays 165 illustrated in FIGS. 3A-C. Further, the elements discussed herein may be implemented with conventional circuit components, as illustrated, or with any type of circuit components configured to perform the same or equivalent functions.

When writing data to a selected resistive memory cell 175 that includes an MRAM memory cell 265, each of the data storage devices illustrated in FIGS. 3A-C may apply a first current with a first voltage source (not shown in FIGS. 3A-C) and may apply a second current to the selected bit line 190 with a second voltage source 230. The combined application of the first voltage source and second voltage source 230 can generate enough of a cumulative coupled magnetic field in the selected resistive memory cell 175 to change the selected resistive memory cell 175 between the parallel and anti-parallel states discussed above. Hence, either a "0" or "1" data bit may be written to the selected resistive memory cell 175 by applying sufficient voltage to the selected word line 180 and the selected bit line 190.

Although resistive memory cells 170, 173, 175, 177 are often written to one at a time, many resistive memory cells 170, 173, 175, 177 may also be written to simultaneously by applying an external magnetic field to a plurality of resistive memory cells 170, 173, 175, 177 in the array 165. This applied magnetic field, when of sufficient intensity, simultaneously changes the direction of magnetization of the soft ferromagnetic layers 150 of all of the affected resistive memory cells 170, 173, 175, 177.

Writing simultaneously to many resistive memory cells 170, 173, 175, 177 may be useful, for example, to perform a bulk erase of all of the data bits stored in the data storage device. In such instances, all soft ferromagnetic layers 150 may be re-set to the same direction of magnetization, effectively writing "0" data bits to all of the affected resistive memory cells. Another possible use of an external magnetic field involves simultaneously setting the directions of magnetization of all of the fixed ferromagnetic layers 130 in an array 165. This involves using a very strong magnetic field and may be done during the manufacturing of the data storage device or during the initial setup of the array 165.

When reading from any of the arrays 165 illustrated in FIGS. 3A-C, instead of the first voltage source discussed above, a ground 220 may be electrically connected to the selected word line 180 and the second voltage source 230 may be electrically connected to the selected bit line 190. Once the ground 220 and second voltage source 230 are electrically connected, a signal current 237 (shown as a solid line in FIGS. 3A-3C) and an undesired current 239 (shown as a dotted line in FIGS. 3A-3C) can begin flowing across the electrical equivalent elements of the resistive memory cells 170, 173, 175, 177, as illustrated in FIGS. 3A-C. These currents 237, 239 develop since each resistive memory cell 170, 173, 175, 177 is electrically coupled between the ground 220 and the second voltage source 230. The currents I₁, I₂, I₃, I₄ illustrated in FIGS. 3A-C represent the cumulative current (signal current 237 plus undesired current 239) flowing through an individual resistive memory cell 170, 173, 175, 177.

A reading operation involves monitoring the amount of signal current 237 that is flowing across the selected resistive memory cell 175. Then, using the signal current 237 value monitored, it is determined whether the selected resistive memory cell 175 is in a parallel or anti-parallel state, and the selected resistive memory cell 175 is assigned a data value of "0" or " 1", based on its resistive state.

If each resistor is assumed to have a resistance value of Rₘ and each diode 260 is assumed to have one of two resistance values, R_{diode_fwd} and R_{diode_rev}, depending on the direction of current through the diode 260, then each resistor and diode 260 equivalent element pairing in FIGS. 3A-C has a resistance substantially equal to either Rₘ+R_{diode_fwd} or Rₘ+R_{diode}__{rev.} R_{diode_fwd} is a function of the forward current through the diode 260 and is generally much less than Rₘ. R_{diode_rev} is a measure of the leakage current across the diode 260 when the diode 260 is under a reverse bias. Hence, R_{diode_rev} is generally much greater than Rₘ.

If there are x rows and y columns in the array 165 illustrated in FIG. 3A, then the pairing in the first unselected resistive memory cell 170 has a resistance of (Rₘ+R_{diode_}f_{wd})/(x-1), the pairing in the second unselected resistive memory cell 177 has a resistance of (Rₘ+R_{diode_fwd})/(y-1), and the pairing in the third unselected resistive memory cell 173 has a resistance of (Rₘ+R_{diode_rev})/[(x-1)(y-1)]. Hence, the selected resistive memory cell 175, with an equivalent resistance of Rₘ+R_{diode_fwd}, has a higher resistance than either the first unselected resistive memory cell 170 or the second unselected resistive memory cell 177 and, depending on the value of x and y, may be greater than or less than the third unselected resistive memory cell 173. Generally, the array 165 may be designed such that the resistance of the third unselected resistive memory cell 173 is much greater than the resistance of the selected resistive memory cell 175.

When one voltage source 230 and one ground 220 are electrically connected to the array 165, as shown in FIG. 3A, the current I₁ flows across the selected resistive memory cell 175 and currents I₂, I₃, I₄ may flow across the unselected resistive cells 170, 173, 177, depending on the orientation of the diode equivalent elements in each cell. As the array size increases, the number of current paths similar to I2, I3, I4 are increased. Thus, the undesired current 239 may become large as compared to the signal curretn 237 and may obscure the signal current 237 during the reading operation. Hence, it may be difficult to read data bits stored in the array 165 when only one voltage source 230 and one ground 220 are used.

This is true even when the equivalent elements are positioned as shown in FIG. 3A. Specifically, the diode equivalent element in the third unselected resistive memory cell 173 nominally blocks currents I₂, I₃, I₄ as the signal current 237 and undesired current 239 flow through the array 165. However, because the array 165 may contain a large number of resistive memory cells, the undesired current 239 may not be completely blocked by this diode and may continue to interfere with the reading of data bits.

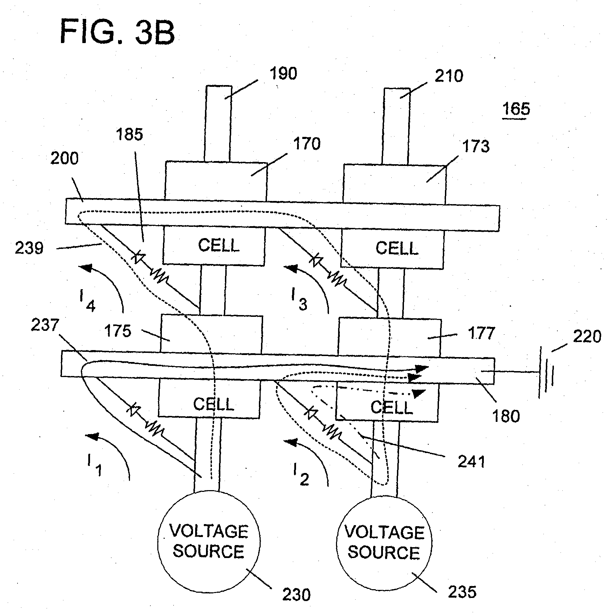

FIG. 3B illustrates one method for reducing the effect of the undesired current 239 by adding a third voltage source 235. When the third voltage source 235 is electrically connected to an unselected bit line 210, and particularly when the voltage from the second voltage source 230 is substantially equal to the voltage from the third voltage source 235, the current I₃ flowing across the third unselected resistive memory cell 173 and the current I₄ flowing across the first unselected resistive memory cell 170 are substantially reduced or eliminated. Further, the additional undesired current 241 flowing across the second unselected resistive memory cell 177 is directed toward the ground 220 and does not directly interfere with the measurement of the signal current 237.

The additional undesired current 241 flowing across the second unselected resistive memory cell 177 may add to the selected row current and may cause an undesirable voltage drop. However, the benefit of reducing the undesired current 239 flowing across the third unselected resistive memory cell 173 and the undesired current 239 flowing across the first unselected resistive memory cell 170 is generally greater than the undesirable effect of the additional undesired current 241 flowing across the second unselected resistive memory cell 177. The voltage coupled from the unselected bit line 210 to the unselected word line 200 establishes a condition for the diode in the first unselected resistive memory cell 170 to block the additional undesired current 239 flowing across the second unselected resistive memory cell 177. Hence, determining the resistive state of the selected resistive memory cell 175 is simplified.

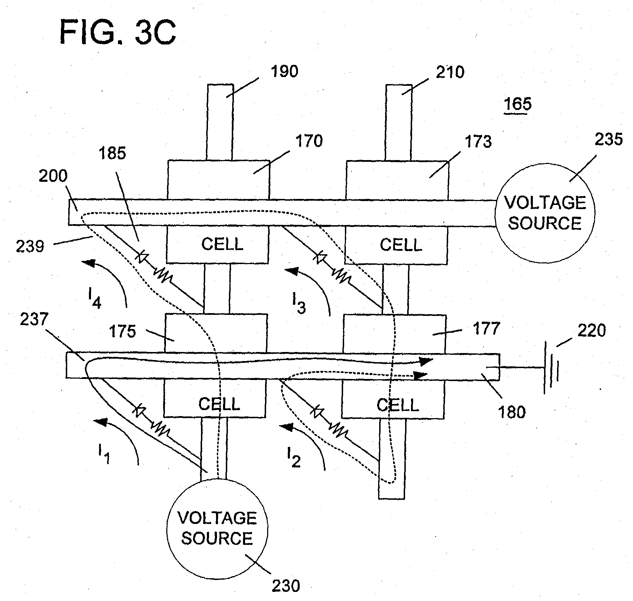

When the third voltage source 235 is electrically connected to the unselected word line 200, as illustrated in FIG. 3C, and particularly when the voltage from the second voltage source 230 is substantially equal to or less than the voltage from the third voltage source 235, the current I₄ flowing across the first unselected resistive memory cell 170 is substantially eliminated. The voltage applied to the unselected word line 200 establishes a condition for the diode 260 in the first unselected resistive memory cell 170 to block the current I₄ and also establishes the condition in the third unselected resistive memory cell 173 to block current I₃. The current I₂ is substantially equal to the current I₃ so that the application of the third voltage source 235 blocks current I₂ from flowing across the second unselected resistive memory cell 177. In addition, the currents I₂, I₃ directed to the ground 220 are blocked by the diode in the third unselected resistive memory cell 173 and, as with the configuration illustrated in FIG. 3B, do not interfere with the measurement of the signal current 237 or with the determination of the resistive state of the selected resistive memory cell 175.

In addition to the reduction in undesired currents obtained with the use of the third voltage source 235, use of the diodes 260 further reduces and/or prevents undesired currents from flowing through the unselected resistive memory cells 170, 173, 177. Even using thin-film, leaky isolation diodes can improve the beneficial effects of using the third voltage source 235.

Another advantage of the data storage device illustrated in FIGS. 3A-C is that the series diodes 260 increase the effective impedance through the unselected resistive memory cells 170. The high impedance reduces the attenuation of the current sensed during the reading operation and has been shown to reduce noise. Both effects combined yield a greater signal-to-noise figure of merit in MRAM circuits with series diodes 260.

Yet another advantage or benefit of the series diodes is to improve write current uniformity. This is accomplished because of the increased resistance through unselected paths through the MRAM array during write operations.

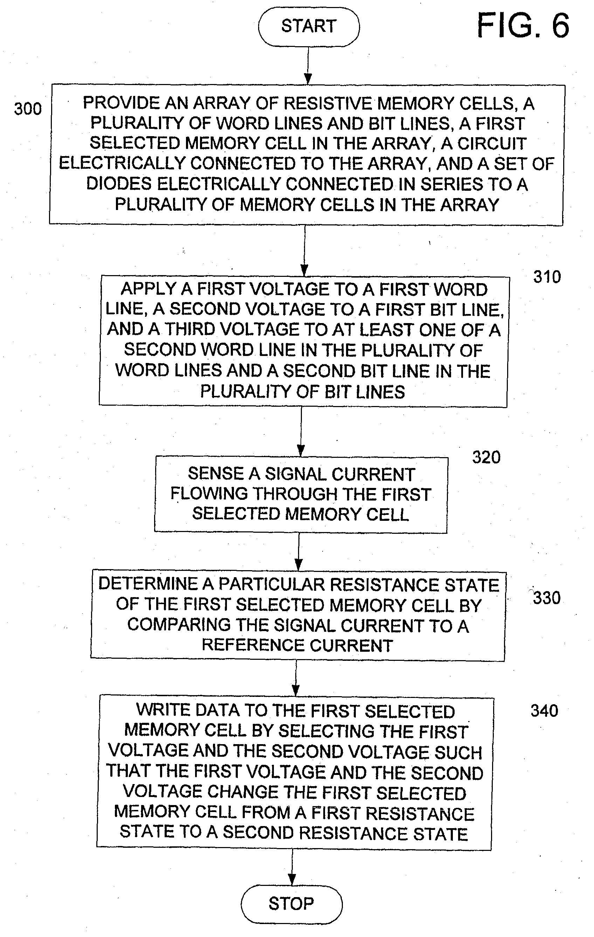

FIG. 6 is a flowchart of a method that may be used to write data to and read data from a data storage device that includes an array 165. According to the method, step 300 specifies that an array 165 of resistive memory cells 170, 173, 175, 177 be provided, along with a plurality of word lines 180, 200 and bit lines 190, 210, a first selected resistive memory cell 175 in the array 165, a circuit that is electrically connected to the array 165, and a set of diodes 260 that are electrically connected in series to a plurality of resistive memory cells 170, 173, 175, 177 in the array 165. According to step 300, the provided diodes 260 may be thin-film diode of any geometry known in the art and may be electrically connected in series with the plurality of resistive memory cells.

Step 310 specifies applying a first voltage to a first word line 180, a second voltage to a first bit line 190, and a third voltage to at least one of a second word line 210 in the plurality of word lines and a second bit line 200 in the plurality of bit lines. The first voltage may be in the form of a ground 220 (zero volts) when reading from the device or may be a high voltage when writing to the device.

In some methods, the third voltage may be applied to at least two word lines other. than the first word line. According to these methods, the array 165 is large, contains many word lines 180, 200, and has a voltage, such as the third voltage source 235 described above, applied to two or more of the unselected word lines 200. According to other alternate methods, the third voltage may be applied to at least two bit lines other than the first bit line. When using one of these methods, the array 165 is again large and has a voltage such as the third voltage source 235 applied to two or more of the unselected bit lines.

Some of the methods of writing to and reading from the data storage device include applying the first voltage and the third voltage in substantially equal amounts. Such methods tend to minimize the amounts of unwanted current 239 in the array 165, whereas application of unequal voltages generally increases the amounts of the unwanted current 239.

Step 320 specifies sensing a signal current 237 flowing through the first selected resistive memory cell 175. The signal current 237 can be sensed as it flows through a single layer of cells 170, 173, 175, 177 or can be sensed as it flows through a selected resistive memory cell 175 that is positioned in a stacked configuration, such as illustrated in FIG. 5. The selected resistive memory cell 175 can be, according to certain methods, chosen to be an MRAM memory cell 265.

Step 330 specifies determining a particular resistance state of the first selected resistive memory cell 175 by comparing the signal current 237 to a reference current value. According to certain methods, the reference current value may be the amount of the first selected resistive memory cell 175 when it is either in the parallel or anti-parallel state. Comparing the reference current value to the amount of signal current 237 sensed allows for a determination to be made concerning which state the first selected resistive memory cell 175 is in.

Step 340 specifies writing data to the first selected resistive memory cell 175 by selecting the first voltage and the second voltage such that the first voltage and the second voltage change the first selected resistive memory cell 175 from a first resistance state to a second resistance state. This step just provides enough current across the selected resistive memory cell 175 to change it between a parallel and anti-parallel state.

The forgoing detailed description has been given for understanding exemplary implementations of data storage devices and methods for using data storage devices. No unnecessary limitations should be understood therefrom, as modifications will be obvious to those skilled in the art without departing from the scope of the appended claims and their equivalents.

## Claims

1. A data storage device comprising:
an array (165) of resistive memory cells (170, 173, 175, 177) having rows and columns;
a set of diodes (260) electrically connected in series to a plurality of resistive memory cells (170, 173, 175, 177) in the array (165);
a plurality of word lines extending along the rows of the array (165);
a plurality of bit lines extending along the columns of the array (165);
a first selected resistive memory cell (175) in the array (165), wherein the first selected resistive memory cell (175) is positioned between a first word line (180) in the plurality of word lines and a first bit line (190) in the plurality of bit lines; and
a circuit electrically connected to the array (165) and capable of applying a first voltage to the first word line (180), a second voltage to the first bit line (190), and a third voltage to at least one of a second word line (200) in the plurality of word lines and a second bit line (210) in the plurality of bit lines.

2. The device of claim 1, wherein the array (165) of resistive memory cells (170, 173,175,177) comprises a magnetic random access memory (MRAM) cell (265).

3. The device of claim 1, further comprising a second resistive memory cell (170, 173, 175, 177) in the array (165), wherein the second resistive memory cell (170, 173, 175, 177) is stacked upon the first selected resistive memory cell (175).

4. The device of claim 1, wherein the circuit is capable of writing to the first selected resistive memory cell (175) by applying sufficient energy to the first word line (180) and the first bit line (190) to transform the first selected resistive memory cell (175) from a first resistance state to a second resistance state.

5. The device of claim 1, wherein values of the first voltage and the third voltage are substantially equal.

6. A method of sensing a resistance state of a first selected resistive memory cell (175) in a data storage device that includes an array (165) of resistive memory cells (170, 173, 175, 177), a plurality of word lines (180, 200) extending along rows of the array (165), a plurality of bit lines (190, 210) extending along columns of the array (165), the first selected resistive memory cell (175) in the array (165), wherein the first selected resistive memory cell (175) is positioned between a first word line (180) in the plurality of word lines and a first bit line (190) in the plurality of bit lines, and a circuit electrically connected to the array (165), the method comprising:
providing a set of diodes (260) electrically connected to a plurality of resistive memory cells (170,173,175,177) in the array (165);
applying a first voltage to the first word line (180), a second voltage to the first bit line (190), and a third voltage to at least one of a second word line (200) in the plurality of word lines and a second bit line (210) in the plurality of bit lines; and
sensing a signal current flowing through the first selected resistive memory cell (175).

7. The method of claim 6, further comprising determining a particular resistance state of the first selected resistive memory cell (175) by comparing the signal current to a reference current value.

8. The method of claim 6, wherein the sensing step comprises sensing the signal current flowing through a magnetic random access memory (MRAM) cell (265).

9. The method of claim 6, wherein the applying step comprises applying the first voltage and the third voltage having substantially equal values.

10. The method of claim 6, further comprising writing data to the first selected resistive memory cell (175) by selecting the first voltage and the second voltage such that the first voltage and the second voltage change the first selected resistive memory cell (175) from a first resistance state to a second resistance state.
